# FASCICULE DE BREVET EUROPEEN

(11) **EP 2 322 469 B1**
(45) Date de publication et mention de la délivrance du brevet: **04.04.2018**
(21) Numéro de dépôt: 10354073.8
(22) Date de dépôt: 08.11.2010
(51) Int. Cl.: B81B 7/00, H01L 23/26, H01L 23/10

(54) **Getter ayant deux températures d'activation et structure comportant ce getter**
Getter mit zwei Aktivierungstemperaturen, und diesen Getter umfassende Struktur
Getter with two activation temperatures and structure comprising said getter

(30) Priorité: 17.11.2009 FR 0905520
(43) Date de publication de la demande: 18.05.2011
(73) Titulaire: Commissariat à l'Énergie Atomique et aux Énergies Alternatives, 75015 Paris (FR)
(72) Inventeur: Baillin, Xavier, 38920 Crolles (FR)
(74) Mandataire: Talbot, Alexandre

(56) Documents cités:
- EP-A1- 1 640 333
- WO-A1-2008/071906
- FR-A1- 2 922 202
- US-A1- 2006 284 556
- US-A1- 2008 226 902
- US-B2- 7 042 075

## Description

### Domaine technique de l'invention

L'invention est relative à un getter monobloc comportant une première couche getter et une structure comportant un tel getter monobloc.

### État de la technique

L'intégration sous vide permet à de nombreux dispositifs, par exemple microélectroniques, tels que les systèmes micro électro mécaniques (MEMS ou « Micro Electro Mechanical Systems » en anglais) d'améliorer leurs performances. Cependant, l'utilisation d'une encapsulation sous vide ou sous atmosphère contrôlée engendre de nombreux problèmes, et notamment la tenue dans le temps du niveau du vide et la qualité de l'atmosphère encapsulée.

Dans cette voie, les matériaux getters non-évaporables (N.E.G. ou « Non Evaporable Getter » en anglais) déposés en couches minces ont fait l'objet de nombreuses publications. Ces matériaux réagissent et capturent des gaz par adsorption de surface et/ou absorption dans le volume. De cette manière, la désorption des matériaux délimitant une cavité sous vide est compensée par la couche en matériau getter qui adsorbe et/ou absorbe les éléments désorbés des autres matériaux.

L'intégration de deux getters différents dans une cavité fermée au sein d'une structure d'encapsulation a déjà été décrite dans la littérature afin de pouvoir conserver dans le temps un vide acceptable.

Cependant, la réalisation de deux getters différents implique une complexification du procédé de réalisation, notamment la multiplication des étapes de photolithographie et gravure, une augmentation non négligeable de la surface occupée par les getters et une augmentation du prix de la structure finale.

Le document FR 2922202 décrit la réalisation d'un getter sur une sous-couche d'ajustement de manière à modifier la température d'activation. Le document US 2006/0284556 décrit la réalisation d'un getter sur un capot refermant une cavité et éventuellement sur les parois latérales avec des compositions chimiques différentes.

Le document US 7,042,075 décrit l'utilisation d'un getter dans une cavité. Le getter est déposé en partie sur une couche de diélectrique et en partie sur une couche électriquement conductrice.

### Objet de l'invention

L'invention a pour objet un getter qui soit facile à mettre en oeuvre, qui soit très compacte et qui permette un contrôle de la pression dans la cavité fermée d'une structure.

Le getter selon l'invention est caractérisé en ce que la première couche getter présente au moins des première et deuxième zones getters ayant des structures cristallines différentes, les première et deuxième zones getters ayant des températures d'activation différentes.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 et 2 représentent, de manière schématique, en coupe, différents modes de réalisation d'une structure selon l'invention,
- les figures 3 et 4 représentent, de manière schématique, en coupe et en vue de dessus, un premier mode de réalisation d'un getter monobloc, selon l'invention,
- la figure 5 représente de manière schématique, en coupe, une première variante de réalisation d'un getter monobloc, selon l'invention,
- les figures 6 et 7 représentent de manière schématique, en coupe et en vue de dessus, une deuxième variante de réalisation d'un getter monobloc, selon l'invention,
- la figure 8 représente de manière schématique, en vue de dessus, une troisième variante de réalisation d'un getter monobloc, selon l'invention,
- les figures 9 et 10 représentent de manière schématique, en coupe et en vue de dessus, une quatrième variante de réalisation d'un getter monobloc, selon l'invention,
- la figure 11 représente de manière schématique, en vue de dessus, une cinquième variante de réalisation d'un getter monobloc, selon l'invention,
- la figure 12 représente de manière schématique, en vue de dessus, une sixième variante de réalisation d'un getter monobloc, selon l'invention,
- la figure 13 représente de manière schématique, en coupe, une septième variante de réalisation d'un getter monobloc, selon l'invention.

### Description de modes de réalisation préférentiels de l'invention

La structure comporte une cavité fermée sous atmosphère contrôlée à l'intérieur de laquelle se trouve au moins un getter monobloc. La cavité comporte avantageusement un élément actif, par exemple un circuit intégré, un microsystème électromécanique, un détecteur et/ou un émetteur de rayonnement lumineux. La cavité fermée est étanche et il y règne une pression inférieure à la pression atmosphérique, avantageusement la cavité est sous vide. La faible pression dans la cavité permet d'améliorer les performances ou la durée de vie des dispositifs actifs, typiquement des microsystèmes électromécaniques, disposés dans la cavité. La cavité peut également être sous une pression contrôlée d'azote ou d'argon.

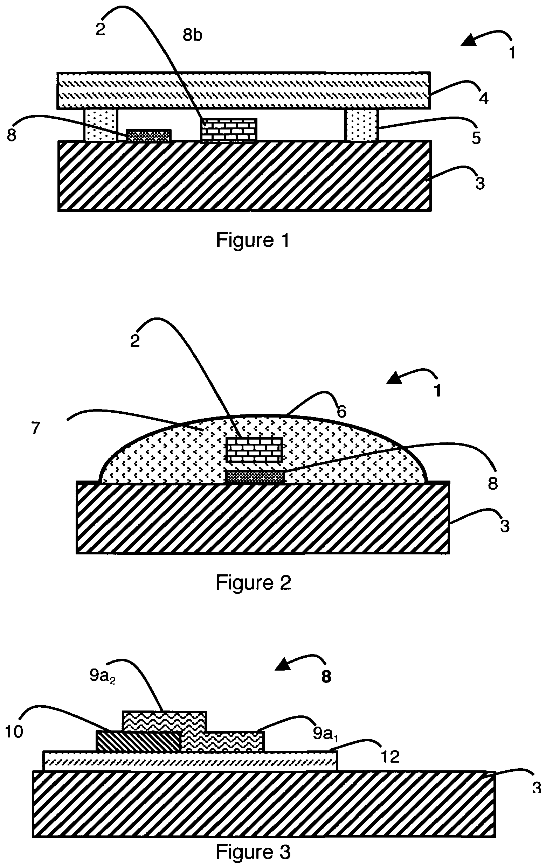

La cavité fermée peut être formée de différentes manières et, à titre d'exemple, deux modes de réalisation différents sont illustrés aux figures 1 et 2. Comme illustré sur la figure 1, la structure 1 comporte au moins un dispositif 2, par exemple de type microélectronique, disposé dans la cavité étanche délimitée par deux substrats 3 et 4 et par un joint de scellement 5 périphérique fermé. L'étanchéité de la cavité est assurée par le joint de scellement 5 situé entre les substrats 3, 4 et qui entoure le dispositif 2. Le joint de scellement 5 est réalisé, par exemple, par la fusion d'un alliage eutectique, par scellement moléculaire ou par scellement anodique. Le dispositif microélectronique 2 est, par exemple, formé sur le premier substrat 3.

Classiquement, la hauteur de la cavité est définie par la hauteur du joint de scellement 5 qui entoure le dispositif 2 (figure 1). Cependant, le second substrat 4 peut être structuré de manière à former un capot comportant une partie centrale plus mince, de manière à augmenter le volume de la cavité. Le second substrat 4 est, par exemple, en silicium, en silicium oxydé ou nitruré ou en verre. Le premier substrat 3 est, par exemple, en silicium ou tout autre matériau semi-conducteur, à l'exception de l'arséniure de gallium (GaAs), ou alors en un autre matériau sur lequel un dispositif déjà formé peut être intégré.

Dans un autre mode de réalisation, illustré à la figure 2, la structure 1 comporte une cavité fermée et étanche qui est délimitée par le substrat 3 et par une couche d'encapsulation 6. L'étanchéité de la structure est alors assurée par l'adhérence entre la couche d'encapsulation 6 et le substrat 3. La couche d'encapsulation joue le rôle d'un capot de fermeture comme le substrat 4 de la figure 1. Le capot de fermeture peut comporter d'autres couches en plus de la couche d'encapsulation. Dans le mode de réalisation illustré à la figure 3, la hauteur de la cavité est définie par l'épaisseur d'un matériau sacrificiel 7 déposé sur le substrat.

L'atmosphère dans la cavité ayant un effet sur la performance et/ou sur la durée de vie des dispositifs situés dans la cavité, il est nécessaire de contrôler cette atmosphère dans ses constituants et dans sa pression. Il est même avantageux de contrôler cette atmosphère dans le temps, c'est-à-dire de préférence durant toute la durée de vie théorique de la structure.

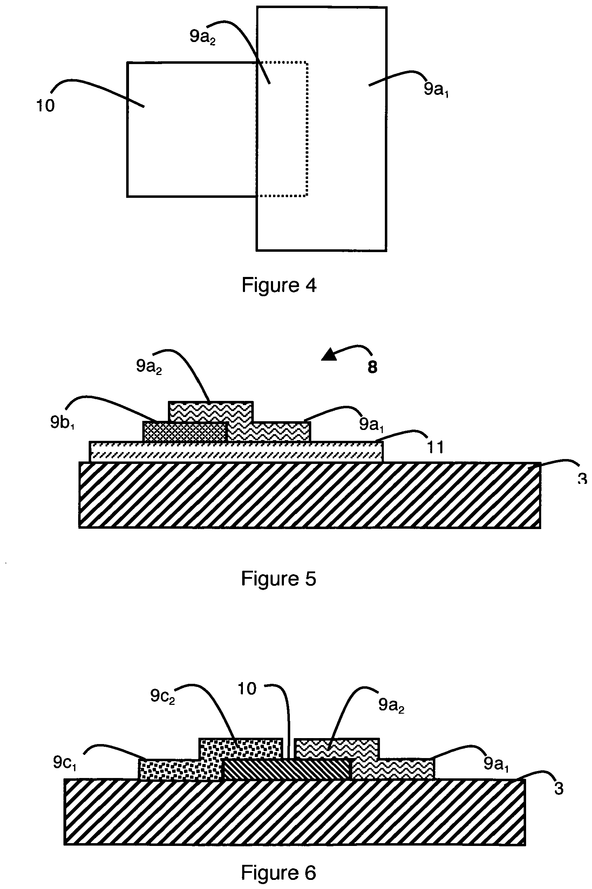

Comme illustré aux figures 3 et 4, afin d'atteindre cet objectif, la structure 1 comporte au moins un getter monobloc 8 qui présente au moins deux températures d'activation différentes, le getter étant disposé dans la cavité. Le getter monobloc 8 comporte une première couche getter 9a qui est formée par un premier matériau à effet getter. La première couche getter 9a présente au moins des première 9a₁ et deuxième 9a₂ zones getters ayant des températures d'activation différentes. La deuxième zone getter 9a₂ présente une température d'activation différente de la première zone 9a₁ car elle présente une structure cristalline différente de celle de la première zone getter 9a₁.

La première 9a1 et la deuxième 9a2 zones getters sont formées simultanément. La deuxième zone getter 9a₂ est formée sur une sous-couche d'ajustement 10 de la température d'activation de matériau getter ce qui a pour effet de modifier la structure cristalline lors de la croissance. En effet, lors du dépôt d'un matériau getter 9 sur deux matériaux différents, le matériau getter 9 présente simultanément deux structures cristallines différentes 9₁, 9₂ bien qu'il ne forme qu'un seul film. La première couche getter 9a est formée en partie sur la sous-couche d'ajustement 10 et en partie hors de la sous-couche d'ajustement 10, par exemple sur le substrat ou sur le film qui recouvre le substrat.

La structure cristalline est fonction des conditions opératoires du procédé de dépôt du matériau getter. La structure cristalline est également fonction de la structure cristalline de la couche sur laquelle le matériau est déposé. Le getter monobloc comporte donc un film continu qui réagit à deux températures d'activation distinctes, chaque température d'activation étant propre à une structure cristalline particulière présente dans le film continu en premier matériau à effet getter. La couche getter réagit avec l'atmosphère présente afin de capter par absorption ou adsorption des atomes ou molécules tels que O₂, N₂, H₂O, CO, CO₂ et H₂.

Il est donc possible de définir les températures d'activation de la couche getter 9 en choisissant le matériau à effet getter qui la compose, ses conditions opératoires de dépôt et la structure cristalline de la sous-couche d'ajustement sur laquelle elle est partiellement formée.

La sous-couche d'ajustement 10, située sous et en contact avec la couche getter 9, est destinée à permettre la modulation de la température d'activation de la couche getter 9, c'est-à-dire de moduler la température à laquelle la couche getter 9 réagit avec l'atmosphère présente à l'intérieur de la cavité. La sous-couche d'ajustement a pour effet de moduler la structure cristalline de la couche getter par rapport aux conditions opératoires du dépôt.

La sous-couche d'ajustement 10 est, de préférence, en Cu, Ni, Pt, Ag, Ru, Cr, Au, Al et présente une épaisseur comprise, de préférence, entre 50 et 500 nm lorsque l'épaisseur de la couche getter 9 est de l'ordre de plusieurs centaines de nanomètres, typiquement entre 100 et 2000nm. L'épaisseur de la sous-couche d'ajustement 10 peut être réduite à quelques dizaines de nanomètres, typiquement entre 10 et 100nm, lorsque la couche getter 9 est de quelques centaines de nanomètres, typiquement entre 100 et 1000nm.

A titre d'exemple, une sous-couche d'ajustement 10 de 30nm est suffisante pour une couche getter 9 de 300nm. L'épaisseur minimale de la sous-couche d'ajustement 10 est approximativement entre 5% et 10% de l'épaisseur de la couche getter 9, par exemple égale à 8%.

Plus généralement, la sous-couche d'ajustement 10 est, par exemple, en un matériau métallique, à l'exception du palladium, déposé à l'état de corps pur qui comme le platine, par exemple, est chimiquement neutre vis-à-vis de la couche getter 9 dans le domaine d'activation recherché. La sous-couche d'ajustement 10 peut aussi être en un matériau getter tel que le titane ou le zirconium par exemple. Lorsque la sous-couche d'ajustement 10 a un effet getter, l'empilement formé par la sous-couche d'ajustement et par la couche getter 9 permet d'absorber une plus grande quantité de gaz car le volume en matériau getter est plus important.

Lors du dépôt de la première couche getter 9a, la seconde zone getter 9a₂ se forme avec une structure cristalline différente de celle de la première zone getter 9a₁, ce qui se traduit par une différence dans les températures d'activation. En effet, la structure cristalline de la seconde zone getter 9a₂ est modifiée par l'influence de la structure cristalline de la sous-couche d'ajustement 10. La première zone getter 9a₁ n'étant pas formée sur la sous-couche d'ajustement 10 sa structure cristalline dépend de sa température de dépôt et du substrat sur lequel elle croît. De cette manière, le getter monobloc 8 présente deux zones distinctes ayant deux températures d'activation car la première couche getter 9a présente deux zones 9a₁ et 9a₂ ayant des structures cristallines différentes (figure 4).

Ainsi, le getter monobloc 8 comporte au moins une couche getter 9 continue qui réagit à deux températures d'activation différentes. Il est donc plus compact que deux getters distincts car il n'est pas nécessaire de prendre en compte des marges de sécurité liées aux différentes étapes de photolithographies. Ainsi, dans la structure, toute la surface dévolue à la partie getter est utilisée pour le pompage de l'atmosphère alors que dans l'art antérieur, une partie est perdue à cause des marges de sécurité.

Le procédé de réalisation étant plus simple à mettre en oeuvre, il est plus économique, plus rapide, il diminue les risques de non compatibilité physicochimique entre les différents matériaux utilisés et la pollution des dispositifs déjà formés en limitant les étapes technologiques.

Dans une première variante de réalisation, illustrée à la figure 5, le getter monobloc 8 comporte une première couche getter 9a et une deuxième couche getter 9b. La première couche getter 9a est formée sur la deuxième couche getter 9b et également à coté de la première couche getter 9a. La deuxième couche getter 9b, peut être dans un deuxième matériau à effet getter qui est différent du matériau de la première couche getter 9a. Il est également possible que les première 9a et deuxième 9b couches getters soient dans le même matériau à effet getter, dans ce cas, le matériau getter a été déposé dans des conditions opératoires différentes pour que la structure cristalline soit différente entre les deux couches getter 9a et 9b. La deuxième couche getter 9b joue alors le rôle de la sous-couche d'ajustement 10 et présente en plus la fonction de getter. La partie non recouverte de la deuxième couche getter 9b, c'est-à-dire la partie libre, réagit comme une zone getter alors que la partie recouverte n'intervient pas dans l'adsorption des molécules de gaz mais en tant que réservoir. Ainsi, la troisième zone getter est formée par une partie de la deuxième couche getter.

Dans un mode de réalisation particulier, il est possible de former un réservoir en matériau getter qui ne présente pas de surface libre. Ce réservoir peut être activé de façon à régénérer totalement ou partiellement la capacité de pompage de la couche getter 9 qui recouvre le réservoir. Le matériau getter formant le réservoir présente sa propre température d'activation. Lorsque le réservoir est activé, il y a déplacement des molécules et/ou des atomes absorbé depuis la couche getter vers le réservoir.

Le getter monobloc 8 comporte des première, deuxième et troisième zones getters ayant des températures d'activation différentes. Deux zones getter 9a₁, 9a₂ sont formées par un même matériau présentant deux zones avec des structures cristallines différentes, la dernière zone getter 9b₁ est formée par un matériau différent. Le getter monobloc peut être représenté en vue de dessus de manière équivalente au getter illustré à la figure 4.

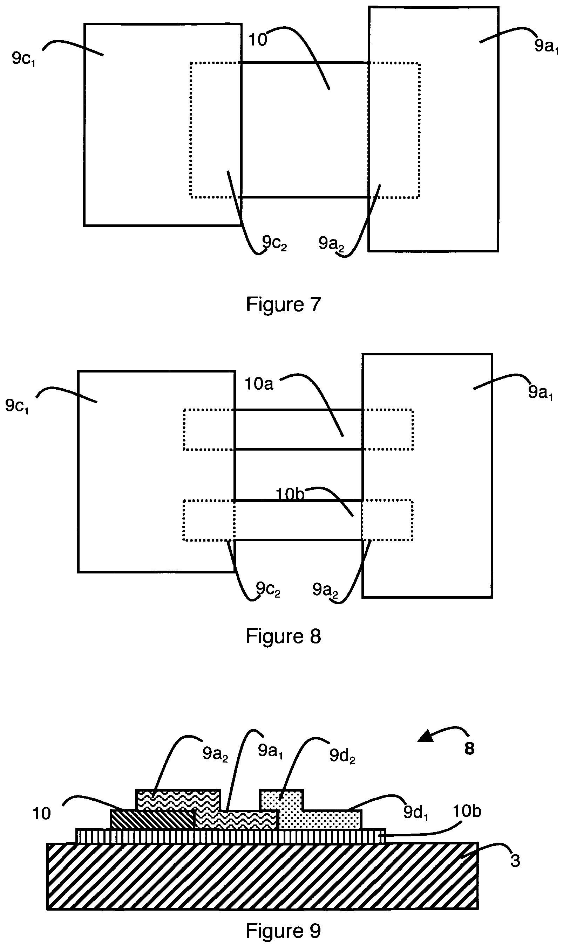

Dans une deuxième variante de réalisation illustrée aux figures 6 et 7 qui peut être combinée avec la variante précédente, le getter monobloc 8 comporte une première couche getter 9a, une sous-couche d'ajustement 10 et une troisième couche getter 9c. Afin d'obtenir une structure extrêmement compact, la première couche getter 9a et la troisième couche getter 9c sont formées sur la sous-couche d'ajustement 10 de la température d'activation et en contact direct avec cette dernière. La première couche getter 9a et la troisième couche getter 9c comportent toutes les deux une portion qui est déposée hors de la sous-couche d'ajustement 10, par exemple sur le substrat. La première couche getter 9a et la troisième couche getter 9c présentent chacune deux zones getters 9a₁, 9a₂, 9c₁ et 9c₂ ayant des structures cristallines différentes.

Le getter monobloc présente alors quatre zones getters. Chacune des zones getters réagit à une température d'activation qui lui est propre. Chaque zone getter est définie par un matériau getter et par une structure cristalline spécifique. Dans ce getter monobloc, deux zones getters sont formées par un même matériau ayant deux structures cristallines distinctes, par exemple la première couche getter 9a et les zones 9a₁ et 9a₂. Deux autres zones getters sont formées par un autre matériau ayant lui aussi deux structures cristallines distinctes, par exemple la troisième couche getter 9c et les zones 9c₁ et 9c₂.

Il est ainsi possible d'obtenir aisément un getter monobloc qui peut réagir à quatre températures d'activation différentes. En choisissant les matériaux utilisés, il est possible de moduler finement la pression dans la cavité et/ou la composition gazeuse dans la cavité en chauffant la structure et donc le getter à une température prédéfinie.

Le getter monobloc 8 obtenu est particulièrement avantageux car les contraintes lithographiques sont minimes ce qui permet d'obtenir un getter compact efficace et à moindre coût. Dans ce mode de réalisation, le getter monobloc comporte deux sous-getters 8a et 8b qui sont formés sur la sous-couche d'ajustement 10, à distance l'un de l'autre. La contrainte lithographique est alors identique à celle de deux getters distincts et adjacents mais ces deux sous-getters 8a, 8b autorisent, ensemble, un ajustement de la pression au moyen de quatre températures d'activation différentes. Le getter monobloc permet alors un réglage plus fin de la pression dans la cavité grâce à un plus grand choix dans les températures accessibles tout en restant compact. Il est également envisageable d'avoir deux couches getters identiques en composition mais qui présentent des différences cristallographiques car elles ont été déposées à des températures différentes. L'utilisation d'un même matériau getter déposé à des températures différentes permet notamment de réduire les risques d'incompatibilité physicochimique.

Dans une troisième variante de réalisation, illustrée à la figure 8, qui peut être combinée avec les modes de réalisation précédents, le getter monobloc 8 comporte une pluralité de sous-couches distinctes, c'est-à-dire au moins deux sous-couches d'ajustement distinctes, ici deux sous-couches 10 et 10b. Les deux sous-couches d'ajustement 10 peuvent être en contact jointif ou être superposées ou alors être séparées. Le getter 8 peut également comporter une ou plusieurs couches getters 9. Chaque couche getter 9 peut recouvrir partiellement toutes les sous-couches d'ajustement 10 ou seulement certaines des différentes sous-couches 10. Ainsi, au moins une couche getter comporte au moins deux zones getters qui régissent à deux températures d'activation différentes. De préférence, toutes les couches getter présente deux zones getters distinctes qui régissent à des températures différentes. Le getter monobloc 8 comporte alors une pluralité de températures d'activation. Chaque température d'activation est associée à une zone getter spécifique qui est définie par son matériau getter constitutif et la structure cristalline.

Dans l'exemple particulier de la figure 8, deux sous-couches d'ajustement distinctes 10a ou 10b sont recouvertes toutes les deux par deux couches getters différentes 9a et 9c. Le getter monobloc est ainsi constitué de six zones getters (9a₁, 9a₂, 9a₃, 9c₁, 9c₂, 9c₃) ayant des températures d'activation différentes. La première couche getter 9a et la troisième couche getter 9c présentent chacune trois types de structures cristallines différentes. Une des structures cristalline est liée au dépôt sur la première sous-couche d'ajustement 10a, une autre structure cristalline est liée au dépôt sur la seconde sous-couche d'ajustement 10b et la dernière est liée au dépôt sur le substrat ou un autre matériau.

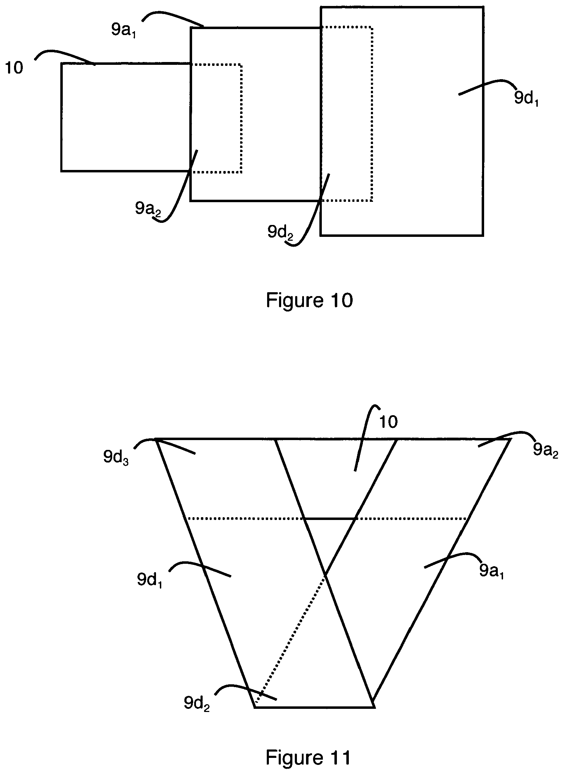

Dans une quatrième variante de réalisation, illustrée aux figures 9 et 10, qui peut être combinée avec les modes de réalisation précédents, le getter monobloc 8 comporte une quatrième couche getter 9d qui présente au moins des première 9d₁ et deuxième 9d₂ zones getters ayant des températures d'activation différentes. La quatrième couche getter 9d est formée partiellement sur la première couche getter 9a et partiellement hors de la première couche getter 9a, par exemple sur le substrat. La première couche getter 9a est formée partiellement sur la sous-couche d'ajustement 10 et partiellement hors de la sous-couche d'ajustement 10, par exemple sur le substrat. La première couche getter 9a présente également des première 9a₁ et deuxième 9a₂ zones getters libres ayant des températures d'activation différentes. Le getter monobloc 8 comporte alors quatre zones getters qui présentent chacune une température d'activation spécifique.

Comme dans les modes de réalisation précédents, les première 9a₁, 9d₁ et deuxième 9a₂, 9d₂ zones getters ont des structures cristallines différentes. La deuxième zone getter 9d₂ de la quatrième couche getter est formée sur la première couche getter 9a. La première couche getter 9a joue le rôle de sous-couche d'ajustement pour une partie de la quatrième couche getter 9d.

La quatrième couche getter 9d est avantageusement formée dans un matériau différent de la première couche getter 9a ou des autres couches getters existantes. Cependant, il est envisageable de prendre le même matériau pour la quatrième couche getter 9d et une autre couche getter 9 existante, par exemple la première couche getter 9a. Les premières zones de la première 9a₁ et de la quatrième 9d₁ couches getters ont alors la même température d'activation si les dépôts des couches 9a et 9d sont réalisés dans les mêmes conditions opératoires. A l'inverse, si les conditions opératoires sont différentes, les premières zones de la première 9a₁ et de la quatrième 9d₁ couches getters ont des températures d'activation différentes.

La deuxième zone getter 9d₂ de la quatrième couche getter 9d délimite une troisième zone de la première couche getter 9a. Cette troisième zone de la première couche getter 9a qui est recouverte par la quatrième couche getter 9d ne participe pas à l'adsorption de la première couche getter 9a, mais elle peut servir de réservoir.

La troisième couche getter 9c et la quatrième couche getter 9d forment une couche getter additionnelle qui est disposée d'une part sur une sous-couche d'ajustement additionnelle et d'autre part hors de cette sous-couche d'ajustement additionnelle. La couche getter additionnelle comporte donc une partie sur la sous-couche additionnelle et une partie hors de la sous-couche additionnelle. Selon les modes de réalisation, la sous-couche d'ajustement additionnelle est choisie parmi la sous-couche d'ajustement 10 et une des couches getters présentes, la première couche getter ou la seconde couche getter. De cette manière, la couche getter additionnelle présente deux températures d'activation différentes entre elles car la couche getter additionnelle présente deux zones ayant respectivement des structures cristallines différentes.

Dans une cinquième variante de réalisation illustrée à la figure 11 qui combine les deuxième et quatrième variantes de réalisation et qui peut être combinée avec la première variante de réalisation, la première couche getter 9a recouvre au moins la sous-couche d'ajustement 10 et une partie du substrat ou d'un autre matériau de support. La quatrième couche getter 9d recouvre également une partie de la sous-couche d'ajustement 10 et une partie du substrat ou d'un autre matériau de support. La quatrième couche getter 9d recouvre en plus, une partie de la première couche getter 9a. La première couche getter 9a comporte alors des première 9a₁ et seconde 9a₂ zones getter. La quatrième couche getter 9d comporte, pour sa part, des première 9d₁, seconde 9d₂ et troisième 9d₃ zones ayant des structures cristallines différentes car elles ont été formées sur des surfaces qui présentaient elles-mêmes des structures cristallines différentes. Les structures cristallines apparentes, du substrat, de la sous-couche d'ajustement 10 et la première couche getter 9a étant différentes, les trois zones getters de la quatrième couche getter 9d ont des structures cristallines différentes. De ce fait, la quatrième couche getter 9d comporte trois températures d'activation différentes, la première couche getter 9a comporte deux températures d'activation différentes et le getter monobloc présente cinq températures d'activation différentes liées chacune à un couple (matériau getter/structure cristalline) unique.

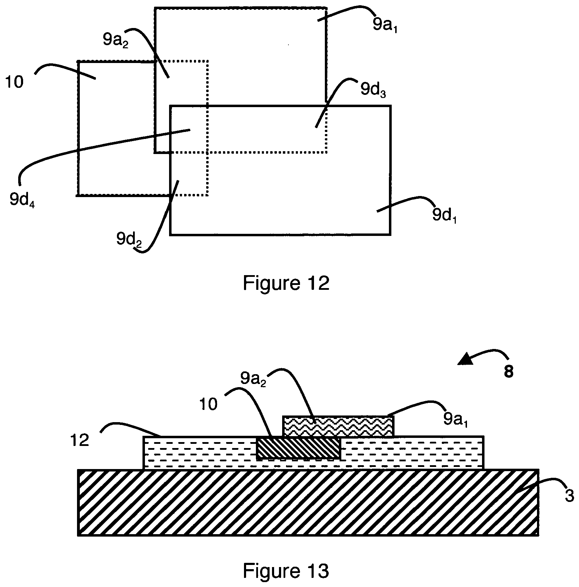

Dans une sixième variante de réalisation illustrée à la figure 12 qui utilise la cinquième variante de réalisation, la première couche getter 9a recouvre au moins la sous-couche d'ajustement 10 et une partie du substrat ou une autre couche support. La quatrième couche getter 9d recouvre également une partie de la sous-couche d'ajustement 10 et une partie du substrat ou une autre couche support. La quatrième couche getter 9d recouvre en plus, une partie de la première couche getter 9a. La quatrième couche getter 9d recouvre une partie de la première couche getter 9a disposée sur la sous-couche d'ajustement 10 et une partie de la première couche getter 9a disposée hors de la sous-couche d'ajustement. Comme la quatrième couche getter 9d recouvre quatre structures cristallines différentes (le substrat, la sous-couche d'ajustement 10 et deux structures cristallines différentes de la première couche getter 9a), la quatrième couche getter 9d comporte des première 9d₁, deuxième 9d₂, troisième 9d₃ et quatrième 9d₄ zones getters différentes. La première couche getter 9a comporte des première 9a₁ et deuxième 9a₂ zones getters.

La seconde zone 9d₂ est formée directement sur la première couche getter 9a, la troisième zone 9d₃ est formée directement sur la sous-couche d'ajustement 10 et la quatrième zone 9d₄ est formée sur une partie de la première couche getter 9a qui est formée directement sur une partie de la sous-couche d'ajustement 10. Cette architecture particulière du getter monobloc 8 permet d'obtenir jusqu'à six températures d'activation différentes sans perte de place entre les différentes zones getters.

Dans encore un autre mode de réalisation, combinable avec les modes de réalisation précédents, il est avantageux de former au moins une partie du getter monobloc sur une sous-couche d'ajustement additionnelle 10b de la température d'activation. La sous-couche d'ajustement 10 est alors formée sur la sous-couche d'ajustement additionnelle 10b. On peut alors si on le souhaite laisser les différentes couches getters chevaucher cette sous-couche d'activation additionnelle afin que le getter monobloc présente au moins trois températures d'activation différentes supplémentaires. A titre d'exemple, une sous-couche d'ajustement additionnelle 10b est illustrée figure 9.

Le getter monobloc 8 peut être formée, au moins partiellement, sur une sous-couche d'accroché 11. La sous-couche d'accroché 11 est destinée à permettre une meilleure adhérence de la sous-couche d'ajustement 10 et/ou des couches getters 9 sur le substrat 3. Pour un substrat de silicium, la sous-couche d'accroché 11 est typiquement réalisée, par toute technique adaptée, par exemple en titane, en chrome ou en zirconium et présente une épaisseur avantageusement comprise entre 20 et 100 nm. A titre d'exemple, une sous-couche d'accroché 11 est illustrée aux figures 3 et 5.

Dans un mode de réalisation particulier qui peut être combiné aux précédents, une fois le getter monobloc formé, une couche de protection est déposée. Cette couche recouvre toutes les surfaces libres du getter et ne modifie pas le fonctionnement général du getter. Cette couche de protection peut être réalisée en chrome, d'une épaisseur avantageusement inférieure à 50nm, ou par une oxydation ou une nitruration de la surface libre du getter. L'oxydation ou la nitruration est réalisée avantageusement par voie sèche. L'oxydation ou la nitruration est avantageusement réalisée après le dépôt du dernier getter et avant d'exposer le getter non protégé à l'air ambiant. Lorsqu'un getter non protégé est exposé à l'air ambiant, il peut être activé par un traitement thermique sous vide secondaire, puis protégé par une couche d'oxyde ou de nitrure, réalisée avant d'exposer de nouveau le getter à l'air ambiant. La couche d'oxyde ou de nitrure est avantageusement formée par voie sèche selon un procédé permettant de contrôler le budget thermique du procédé et la pression.

La couche de chrome est une sous-couche d'ajustement qui peut être utilisée en tant que couche de protection lorsqu'elle présente une très petite taille de grains. Typiquement des grains de l'ordre de 30nm de diamètre ou en dessous. Cette petite taille de grains permet une diffusion à basse température. A titre d'exemple explicatif, le titane réduit l'oxyde de chrome qui est formé lors de la réaction de la couche de chrome avec l'oxygène ambiant. La couche de protection diffuse à la température d'activation ce qui lui donne une effet temporaire. La couche de protection n'est utilisée que jusqu'à son activation. La couche de protection protège la couche getter des agressions chimiques gazeuse ou liquide. Dans une variante de réalisation, la couche de protection peut être retirée, par exemple par gravure liquide avec une solution acide ou alors au moyen d'une gravure par plasma. Avantageusement, la couche de protection est éliminé lorsqu'elle est utilisée avec un dispositif de type MEMS qui est encapsulé.

Dans un mode de réalisation particulier, lorsque la couche de protection est en chrome, la couche de protection est déposée pendant la formation du getter monobloc. Elle est déposée avant la formation d'une couche getter, puis elle est de nouveau déposée après la formation de la couche getter 9. La première couche de protection déposée joue alors le rôle de sous-couche d'ajustement, mais la couche de protection présente au moins deux zones cristallines différentes selon l'endroit où elle est formée. La structure générale du getter monobloc n'est pas modifiée ni son fonctionnement.

Tous ces modes de réalisation permettent, avec une surface restreinte, d'obtenir un dispositif getter présentant une pluralité de températures d'activation différentes. Les techniques utilisées sont conventionnelles ce qui permet une mise en oeuvre aisée et économique. Les contraintes lithographiques sont faibles ce qui permet des gains en surface utilisée importants. Le getter monobloc est d'autant plus avantageux que le nombre de températures d'activation est important car le gain en surface et en facilité de réalisation augmente.

Différents modes de réalisation sont possibles pour former un getter monobloc.

Dans un premier mode de réalisation, illustré aux figures 3, 5, 6 et 9, la sous-couche d'ajustement 10 est formée sur le substrat 3. Un film en matériau d'ajustement est déposé par toute technique adaptée, par exemple, par dépôt physique en phase vapeur PVD, typiquement par évaporation et il est ensuite structuré pour former la sous-couche d'ajustement 10. La structuration est réalisée par toute technique adaptée, par exemple, par photolithographie et gravure (sèche ou humide) ou par une technique dite à décollement (« lift off » en anglais). Ainsi, la sous-couche d'ajustement 10 est formée par un motif en matériau d'ajustement.

Une fois la sous-couche d'ajustement 10 formée, le premier matériau getter est déposé puis structuré pour former la première couche getter 9a du getter monobloc. Le premier matériau getter est donc en contact, dans la première zone 9a₁, avec le substrat 3 et, dans la deuxième zone 9a₂, avec la sous-couche d'ajustement 10. La première couche getter 9a chevauche la sous-couche d'ajustement et le chevauchement délimite la première et la deuxième zone de la première couche getter. La première couche getter 9a recouvre au moins partiellement la sous-couche d'ajustement 10 pour former au moins la deuxième zone getter 9a₂ de la première couche getter 9a et se prolonge hors de la sous-couche d'ajustement 10 pour former au moins la première zone getter 9a. Dans le mode de réalisation illustré aux figures 3, 5, 6 et 9, le chevauchement est représenté par une marche. Les première et deuxième zones getters sont alors séparées par une zone de liaison qui a également un effet getter mais dont la température d'activation est difficile à établir. Dans la mesure où la surface de la zone de liaison est faible devant les surfaces des première et deuxième zones getters, cette zone de liaison est négligée. Le getter monobloc 8 est alors formé par un motif en premier matériau getter qui chevauche un motif en matériau d'ajustement. Le motif en premier matériau getter comporte les deux zones getter ayant des températures d'activation différentes.

Dans un autre mode de réalisation illustré à la figure 13, plus complexe à mettre en place, la sous-couche d'ajustement 10 est formée dans un matériau de structuration 12. Le matériau de structuration 12 est formé et structuré afin de comporter un volume vide qui correspond au futur volume de la sous-couche d'ajustement. Le matériau d'ajustement est ensuite déposé et il remplit au moins le volume vide. Avantageusement, une étape de polissage mécano-chimique est réalisée afin de délimiter la sous-couche d'ajustement 10 dans le matériau de structuration 12 et la première couche getter 9a est déposée et structurée. Dans ce mode de réalisation, la première couche getter est plane, elle comporte les première 9a₁ et seconde 9a₂ zones getters. La seconde zone getter 9a₂ est formée sur la sous-couche d'ajustement 10 qui affleure du matériau de structuration 12. Ce mode de réalisation utilise la technique damascène qui est utilisée couramment dans le domaine des interconnexions métalliques des circuits intégrés.

Ces deux modes de réalisation sont facilement transposables à la réalisation des différentes variantes présentées plus haut dans lesquelles la sous-couche d'ajustement est remplacée par une couche getter d'un sous-getter déjà formé. Ces deux modes de réalisation peuvent être utilisés dans un même getter monobloc.

Le getter monobloc avec au moins deux températures d'activation est formé par au moins une unique couche getter, c'est-à-dire par un unique motif en matériau getter, qui réagit à au moins deux températures d'activation. Le getter monobloc peut avoir différentes formes, les première et seconde zones getters peuvent être dans le même plan, ou dans des plans parallèles, une des zones étant au dessus de l'autre. Les première et seconde zones getters peuvent être formées dans des plans saillants, c'est-à-dire que les surfaces principales des zones getters ne sont pas parallèles. Dans la mesure où certains des procédés de dépôt des sous-couches d'ajustement et des couches getters sont directionnels, il est possible d'obtenir un getter monobloc comportant des températures d'activation différentes selon l'orientation des directions perpendiculaires aux différentes parties du getter monobloc. A titre d'exemple, il est possible de graver une tranchée dans le substrat et de former un getter en forme de L avec des températures d'activation différentes entre le plan vertical et le plan horizontal. La face principale du substrat est, par exemple, recouverte de manière directionnelle par la sous-couche d'ajustement alors que la couche getter est déposée au moyen d'un procédé plus uniforme. Le getter comporte alors une partie horizontale qui présente une sous-couche d'ajustement et une couche getter et une partie verticale sans sous-couche d'ajustement. La surface horizontale du getter est réduite car une partie de la surface de collection du getter est formée dans le substrat.

Dans une variante de réalisation, il est avantageux d'éliminer la sous-couche d'ajustement 10 une fois que la couche getter 9 est formée. La couche getter 9 possède alors deux zones getters distinctes qui présentent des structures cristallines différentes. Le getter monobloc 8 comporte alors au moins une couche getter qui réagit à au moins deux températures d'activation différentes, chaque température d'activation étant associée à une des zones possédant une structure cristallographique particulière.

Dans une autre variante de réalisation, il est avantageux d'avoir une couche getter suspendue, c'est-à-dire une couche qui présente aux moins deux faces opposées libres et parallèles à la face principale du substrat de support afin d'augmenter la vitesse de pompage sans augmenter la surface occupée sur le substrat. Ainsi, en utilisant des getters suspendus, il y a augmentation de la vitesse de pompage sans augmentation de la surface occupée par le getter monobloc, ni augmentation de la quantité de gaz pouvant être absorbé ou adsorbé (à volume de getter constant). Un tel getter suspendu peut être obtenu facilement en éliminant un matériau sacrificiel, par exemple, la sous-couche d'ajustement ou le matériau de structuration 12, un fois le getter formé.

Dans la présente demande, il est fait référence à des zones présentant des structures cristallines différentes. Cette différence de structure se traduit par deux zones polycristalline ayant des structures cristallines différentes. Les deux zones polycristallines présentent des tailles de grains différentes, les deux structures cristallines étant de type polycristal à grains colonnaires.

Dans le getter monobloc, chacune des couches constitutives est en contact direct avec au moins une des autres couches constitutives. Il existe un lien mécanique entre les différentes couches formant le getter monobloc, ce lien se traduit soit par un contact direct entre les différentes couches constituant le getter monobloc soit par un contact indirect provenant d'une couche intermédiaire, par exemple la sous-couche d'ajustement 10. De cette manière, le getter monobloc forme un tout et il n'est possible de déplacer le getter que dans sa totalité, c'est-à-dire l'ensemble des couches getters formant le getter monobloc 8.

D'une manière générale, la surface libre de la zone getter définit la vitesse de pompage de la zone getter alors que son volume définit la quantité totale de gaz qui peut être absorbé par la zone getter. Selon les besoins recherchés, il faut donc trouver un compromis entre la surface libre de zones getters, le volume du getter monobloc et la surface globale du getter qui correspond à une surface perdue dans la future structure qui l'incorpore.

Dans les différents modes de réalisation décrits, le getter monobloc présente un grand nombre de températures d'activation différentes. Cependant, il est possible de réduire le nombre de températures d'activation en ne déposant pas toutes les couches getters sur au moins deux matériaux présentant des structures cristallines différentes. De cette manière, il est possible pour une surface donnée, de définir précisément, les quelques températures d'activation utilisables, leur vitesse de pompage associée et le volume qui peut être éliminé.

A titre d'exemple, pour réduire le nombre de températures d'activation, la quatrième couche getter 9d n'est déposée que sur la première couche getter 9a dans le mode de réalisation illustré à la figure 12, ou elle n'est déposée que la sous-couche d'ajustement 10 et la première couche getter 9a dans le mode de réalisation de la figure 11.

Selon les différents modes de réalisation décrits, le getter monobloc présente des empilements comportant au moins une sous-couche d'ajustement 10 de la température d'activation et une couche getter 9. Des exemples de réalisation incorporent deux ou trois matériaux à effet getter mais il est possible de former des getters monobloc incorporant plus de couches getters différentes. Dans chacun des modes de réalisation, en choisissant astucieusement les matériaux choisis et leur recouvrement au moins partielle, il est possible de former un getter monobloc qui présente plus de zones getters qu'il n'y a de matériaux getters présents. Typiquement, le getter monobloc peut présenter deux fois plus de zones getter ayant une température d'activation propre que le nombre de couches getters présentes.

De manière générale, lorsque le getter monobloc comporte n couches getters distinctes, avec n supérieur ou égal à 1, et l sous-couches d'ajustement de la température d'activation de matériau getter (avec l supérieur ou égal à 1), et lorsque chaque couche getter est disposée sur au moins deux matériaux différents (la couche getter comporte une partie sur une des sous-couches d'ajustement et une autre partie hors de cette sous-couche), il est possible d'obtenir un getter monobloc comportant plus de zones getters différentes que de couches getters (m zones getters avec m>n), typiquement deux fois plus de zones getters que de couches en matériau getter. Chaque zone getter a sa propre température d'activation.

Il est donc possible de former un ou plusieurs getters monoblocs sur un substrat sacrificiel et de placer au moins un de ces getters monoblocs à l'intérieur d'une future cavité fermée. Il est également possible de former avantageusement le getter dans la future cavité. Si la cavité doit présenter une pression comprise dans une certaine gamme, il est avantageux de réaliser le contrôle de la pression au moyen d'une pluralité de températures d'activation. De cette manière, en fonction de la température imposée au getter, un certain volume de matériau getter est activé et intervient pour faire baisser la pression dans la gamme recherchée.

## Revendications

1. Getter monobloc (8) comportant une première couche getter (9a) en un premier matériau getter (9a), dans lequel la surface de pompage de la première couche getter (9a) présente au moins des première (9a₁) et deuxième (9a₂) zones getters ayant des structures cristallines différentes, les première (9a₁) et deuxième (9a₂) zones getters ayant des températures d'activation différentes, **caractérisé en ce que** la première zone getter (9a₁) et la deuxième zone getter (9a₂) possèdent une structure polycristalline avec des grains colonnaires et **en ce que** la première zone getter (9a₁) présente une taille de grain différente de la taille de grain de la deuxième zone getter (9a₂).

2. Getter monobloc selon la revendication 1 **caractérisé en ce que** la deuxième zone getter (9a₂) est disposée sur une sous-couche d'ajustement (10) de la température d'activation de matériau getter.

3. Getter monobloc selon la revendication 2, **caractérisé en ce que** la première zone getter (9a1) et la sous-couche d'ajustement (10) sont formées sur un même substrat (3).

4. Getter monobloc selon l'une des revendications 2 et 3, **caractérisé en ce que** la sous-couche d'ajustement (10) est une deuxième couche getter (9b), le getter monobloc (8) comporte une troisième zone getter disposée dans la deuxième couche getter (9b).

5. Getter monobloc selon l'une quelconque des revendications 2 à 4, **caractérisé en ce que** les première (9a₁) et deuxième (9a₂) zones getters sont formées dans des plans parallèles.

6. Getter monobloc selon l'une quelconque des revendications 2 à 5, **caractérisé en ce que** la première couche getter (9a) chevauche la sous-couche d'ajustement (10) pour former une marche entre les première (9a₁) et deuxième (9a₂) zones getters.

7. Getter monobloc selon l'une quelconque des revendications 2 à 6, **caractérisé en ce qu'**il comporte une couche getter additionnelle (9c, 9d) avec une partie sur une sous-couche additionnelle et une partie hors de la sous-couche additionnelle, la sous-couche additionnelle est choisie parmi la sous-couche d'ajustement (10) et une des couches getters (9a, 9b), la couche getter additionnelle (9c, 9d) présente des première (9c₁, 9d₁) et deuxième (9c₂, 9d₂) zones getters additionnelles ayant respectivement des températures d'activation différentes entre elles.

8. Getter monobloc selon la revendication 7, **caractérisé en ce que** la première couche getter (9a) et la couche getter additionnelle (9c, 9d) sont réalisées dans le même matériau à effet getter, la première couche getter (9a) et la couche getter additionnelle (9c, 9d) présentent des zones getter ayant chacune une structure cristalline différente des autres zones getters.

9. Getter monobloc selon la revendication 8, **caractérisé en ce que** la couche getter additionnelle (9d) est disposée d'une part sur deux zones de la première couche getter (9a) qui présentent des structures cristallines différentes et disposée d'autre part hors de la première couche getter (9a).

10. Getter monobloc selon l'une quelconque des revendications 2 à 9, **caractérisé en ce qu'**il comporte au moins une sous-couche d'ajustement supplémentaire (10b).

11. Getter monobloc selon la revendication 10, **caractérisé en ce qu'**il comporte une pluralité de couche getters (9), chaque couche getter (9) comporte une partie sur une des sous-couches d'ajustement (10a, 10b) et une partie hors de ladite sous-couche d'ajustement de manière que le getter comporte plus de zones getters que de couches getters.

12. Getter monobloc selon l'une quelconque des revendications 1 à 11, **caractérisé en ce qu'**il est au moins partiellement recouvert par une couche de protection.

13. Structure comportant une cavité fermée sous atmosphère contrôlée dans laquelle est disposé au moins un getter monobloc selon l'une quelconque des revendications 1 à 12.

## Patentansprüche

1. Einstückiger Getter (8) mit einer ersten Getter-Schicht (9a) aus einem ersten Getter-Material (9a), wobei die Pump-Oberfläche der ersten Getter-Schicht (9a) mindestens einen ersten und einen zweiten Getter-Bereich (9a₁, 9a₂) mit verschiedenen Kristallstrukturen aufweist, wobei der erste und der zweite Getter-Bereich (9a₁, 9a₂) verschiedene Aktivierungstemperaturen haben,
**dadurch gekennzeichnet,**
**dass** der erste Getter-Bereich (9a₁) und der zweite Getter-Bereich (9a₂) eine polykristalline Struktur mit säulenförmigen Körnern haben, und dass der erste Getter-Bereich (9a₁) eine Korngröße aufweist, die sich von der Korngröße des zweiten Getter-Bereichs (9a₂) unterscheidet.

2. Einstückiger Getter nach Anspruch 1,
**dadurch gekennzeichnet,**
**dass** der zweite Getter-Bereich (9a₂) auf einer Unterschicht zur Regulierung (10) der Aktivierungstemperatur des Getter-Materials angeordnet ist.

3. Einstückiger Getter nach Anspruch 2,
**dadurch gekennzeichnet,**
**dass** der erste Getter-Bereich (9a₁) und die Regulierungs-Unterschicht (10) auf einem und demselben Substrat gebildet sind.

4. Einstückiger Getter nach einem der Ansprüche 2 und 3,
**dadurch gekennzeichnet,**
**dass** die Regulierungs-Unterschicht (10) eine zweite Getter-Schicht (9b) ist, wobei der einstückige Getter (8) einen dritten Getter-Bereich enthält, der in der zweite Getter-Schicht (9b) angeordnet ist.

5. Einstückiger Getter nach einem der Ansprüche 2 bis 4,
**dadurch gekennzeichnet,**
**dass** der erste Getter-Bereich (9a₁) und der zweite Getter-Bereich (9a₂) in parallelen Ebenen gebildet sind.

6. Einstückiger Getter nach einem der Ansprüche 2 bis 5,
**dadurch gekennzeichnet,**
**dass** die erste Getter-Schicht (9a) die Regulierungs-Unterschicht (10) überlappt, um eine Stufe zwischen dem ersten Getter-Bereich (9a₁) und dem zweiten Getter-Bereich (9a₂) zu bilden.

7. Einstückiger Getter nach einem der Ansprüche 2 bis 6,
**dadurch gekennzeichnet,**
**dass** er eine zusätzliche Getter-Schicht (9c, 9d) mit einem Teil auf einer zusätzlichen Unterschicht und einem Teil außerhalb der zusätzlichen Unterschicht aufweist, die zusätzliche Unterschicht aus der Regulierungs-Unterschicht (10) und einer der Getter-Schichten (9a, 9b) gewählt ist, die zusätzliche Getter-Schicht (9c, 9d) erste zusätzliche Getter-Bereiche (9c₁, 9d₁) und zweite zusätzliche Getter-Bereiche (9c₂, 9d₂) aufweist, die jeweils voneinander verschiedene Aktivierungstemperaturen haben.

8. Einstückiger Getter nach Anspruch 7,
**dadurch gekennzeichnet,**
**dass** die erste Getter-Schicht (9a) und die zusätzliche Getter-Schicht (9c, 9d) aus dem gleichen Material mit Getter-Effekt hergestellt sind, die erste Getter-Schicht (9a) und die zusätzliche Getter-Schicht (9c, 9d) Getter-Bereiche aufweisen, die jeweils eine von den anderen Getter-Bereichen unterschiedene Kristallstruktur haben.

9. Einstückiger Getter nach Anspruch 8,
**dadurch gekennzeichnet,**
**dass** die zusätzliche Getter-Schicht (9d) zum einen Teil auf zwei Bereichen der ersten Getter-Schicht (9a) angeordnet ist, die unterschiedliche Kristallstrukturen aufweisen, und zum anderen Teil außerhalb der ersten Getter-Schicht (9a) angeordnet ist.

10. Einstückiger Getter nach einem der Ansprüche 2 bis 9,
**dadurch gekennzeichnet,**
**dass** er mindestens eine zusätzliche Regulierungs-Unterschicht (10b) enthält.

11. Einstückiger Getter nach Anspruch 10,
**dadurch gekennzeichnet,**
**dass** er eine Mehrzahl von Getter-Schichten (9) enthält, jede Getter-Schicht (9) einen Teil über einer der Regulierungs-Unterschichten (10a, 10b) und einen Teil außerhalb dieser Regulierungs-Unterschicht umfasst, so dass der Getter mehr Getter-Bereiche als Getter-Schichten aufweist.

12. Einstückiger Getter nach einem der Ansprüche 1 bis 11,
**dadurch gekennzeichnet,**
**dass** er mindestens zum Teil mit einer Schutzschicht bedeckt ist.

13. Struktur mit einem unter kontrollierter Atmosphäre geschlossenen Hohlraum, in dem mindestens ein einstückiger Getter nach einem der Ansprüche 1 bis 12 angeordnet ist.

## Claims

1. A monoblock getter (8) comprising a first getter layer (9a) made from a first getter material (9a) wherein the pumping surface of the first getter layer (9a) presents at least first (9a₁) and second (9a₂) getter areas having different crystalline structures, the first (9a₁) and second (9a₂) getter areas having different activation temperatures, **characterized in that** the first getter area (9a₁) and the second getter area (9a₂) have a polycrystalline structure with columnar grains and **in that** the first getter area (9a₁) presents a grain size different from the grain size of the second getter area (9a₂).

2. The monoblock getter according to claim 1, **characterized in that** the second getter area (9a₂) is located over an adjustment sub-layer (10) of the getter material activation temperature.

3. The monoblock getter according to claim 2, **characterized in that** the first getter area (9a1) and the adjustment sub-layer (10) are formed on the same substrate (3).

4. The monoblock getter according to one of claims 2 and 3, **characterized in that** the adjustment sub-layer (10) is a second getter layer (9b), the monoblock getter (8) comprising a third getter area arranged in the second getter layer (9b).

5. The monoblock getter according to any one of claims 2 to 4, **characterized in that** the first (9a₁) and second (9a₂) getter areas are formed in parallel planes.

6. The monoblock getter according to any one of claims 2 to 5, **characterized in that** the first getter layer (9a) overlaps the adjustment sub-layer (10) to form a step between the first (9a₁) and second (9a₂) getter areas.

7. The monoblock getter according to any one of claims 2 to 6, **characterized in that** it comprises an additional getter layer (9c, 9d) with a part on an additional sub-layer and a part outside the additional sub-layer, the additional sub-layer is chosen from the adjustment sub-layer (10) and one of the getter layers (9a, 9b), and the additional getter layer (9c, 9d) presents first (9c₁, 9d₁) and second (9c₂, 9d₂) additional getter areas respectively having different activation temperatures from one another.

8. The monoblock getter according to claim 7, **characterized in that** the first getter layer (9a) and additional getter layer (9c, 9d) are made from the same getter effect material, the first getter layer (9a) and the additional getter layer (9c, 9d) presenting getter areas each having a different crystalline structure from the other getter areas.

9. The monoblock getter according to claim 8, **characterized in that** the additional getter layer (9d) is arranged partly on two areas of the first getter layer (9a) which present different crystalline structures and arranged partly outside the first getter layer (9a).

10. The monoblock getter according to any one of claims 2 to 9, **characterized in that** it comprises at least one additional adjustment sub-layer (10b).

11. The monoblock getter according to claim 10, **characterized in that** it comprises a plurality of getter layers (9), each getter layer (9) comprising a part on one of the adjustment sub-layers (10a, 10b) and a part outside said adjustment sub-layer so that the getter comprises more getter areas than getter layers.

12. The monoblock getter according to any one of claims 1 to 11, **characterized in that** it is at least partially covered by a protective layer.

13. A structure comprising a closed cavity under a controlled atmosphere in which at least one monoblock getter according to any one of claims 1 to 12 is arranged.
